# EUROPEAN PATENT APPLICATION

(11) **EP 4 586 305 A1**
(43) Date of publication of application: **16.07.2025**
(21) Application number: 24221347.8
(22) Date of filing: 19.12.2024
(51) Int. Cl.: H01L 21/18, H01L 21/02, H01L 21/20, H01L 21/326

(54) **METHOD FOR LOW TEMPERATURE BONDING OF SUBSTRATES**

(30) Priority: 11.01.2024 NL 2036782
(71) Applicant: SUSS MicroTec Solutions GmbH & Co. KG, 75447 Sternenfels (DE)
(72) Inventor: SCHMIDT, Thomas, 75447 STERNENFELS (DE)
(74) Representative: Prinz & Partner mbB

(57) **Abstract**

The present invention relates to a method for low temperature bonding of substrates (10, 12), comprising the steps of:
providing a first substrate (10) and a second substrate (12);
aligning the first substrate (10) and the second substrate (12);
prebonding the first substrate (10) and the second substrate (12) by a fusion prebonding process; and
bonding the first substrate (10) and the second substrate (12) by applying an electric voltage between the first substrate (10) and the second substrate (12), wherein said voltage comprises a pulsed or AC component.

## Description

The present invention relates to a method for low temperature bonding of substrates.

The packaging density of semiconductor devices significantly increased during recent years. Integrated circuit (IC) devices have become more powerful, yet smaller at the same time. It is an ever-growing challenge to increase the packaging density of the semiconductor devices and metallic interconnects connecting them even further. Special processing strategies and substrate or wafer bonding techniques, such as permanent or temporary substrate/wafer bonding, have been developed to address the technical problems connected to manufacturing such devices.

Furthermore, for processing devices with multiple stacked layers, it can be necessary to connect two substrates by bonding.

A variety of different bonding processes are known from literature.

In the commonly applied fusion bonding process, comprising a fusion prebonding process and a high temperature annealing process, two substrates are chemically bonded together without any additional intermediate layer between them. The bonding is based on intermolecular interactions including van der Waals forces, hydrogen bridges (formed during the fusion prebonding step) and strong covalent bonds between the substrates (formed during the high temperature annealing step).

The quality of the connection strongly depends on the surface roughness, the amount of silanol groups (depending on the efficiency of the plasma surface treatment) and the processing temperature. At moderate bonding temperatures below 200 °C only a limited number of silanol groups form covalent bonds at the bonding interface. In order to achieve a sufficient bonding strength, it is necessary to apply a high temperature annealing step (> 200 °C) over extended time periods, e.g. more than 2 to 10 hours, which increases the number of covalent bonds.

Due to the high processing temperature, especially the high temperature during the annealing step, however, the application of the fusion bond process to bond substrates with different thermal expansion coefficients is limited. Upon cooling of bonded substrate stacks, intrinsic stresses can result in damaging or even breaking of the bonding interface and/or substrates.

Besides the temperature, the quality of the fusion bonding process is also strongly dependent on the surface roughness of the two substrates. Only with smooth surfaces with less than 0.15 nm RMS (Root Mean Square) roughness, a sufficient contacting interface for high quality fusion bonding can be achieved. Hence, cost intensive surface preparation, for example by chemical-mechanical polishing (CMP), is required prior to the bonding process.

Due to the above mentioned drawbacks of the commonly applied bonding methods, there is a need for means to improve bond strength and -process control in general and to decrease the processing time.

The object of the invention is solved by a method for bonding substrates comprising the steps of:
providing a first substrate and a second substrate;
aligning the first substrate and the second substrate;
prebonding the first substrate and the second substrate by a fusion prebonding process; and
bonding the first substrate and the second substrate by applying an electric voltage between the first substrate and the second substrate, wherein said voltage comprises a pulsed or AC component.

The method is especially suitable for bonding wafers, in particular silicon wafers.

By prebonding with the well-known fusion bonding process, the substrates are reversibly bonded to each other. This allows controlling and if necessary correcting their relative position to each other. Furthermore, it facilitates the handling of the substrates without loss of alignment, e.g. for the subsequent bonding step.

In the bonding step, the substrates are strongly bonded together by applying an electric voltage to both substrates, wherein said voltage comprises a pulsed or AC component. Accordingly, the bonding step can be interpreted as an electrically driven bond process.

In particular, after the bonding step, the substrates are permanently bonded and/or inseparably connected to each other.

The bonding step can be especially performed by applying a so-called impulse current bonding (ICB) process, which is applicable to a large number of different substrate materials.

It is believed, without wishing to be limited by theory, that the application of the voltage with the pulsed or AC component stipulates migration of material, such as atoms and/or ions, at the substrate interface.

Furthermore, creation of chemical and/or charge gradients may form at the interface region, which can give rise to covalent and/or ionic bonds between the substrates.

The frequencies of the pulsed or alternating voltage component can be above the dielectric relaxation frequency of the substrate materials used. In particular, the frequencies can be between 0.1 and 100 kHz.

Preferably, the voltage also has a DC component onto which the AC or pulsed component is superimposed. The direction in which the DC component is applied dictates the migration direction of material.

In the method according to the invention, the application of a voltage with AC or pulsed component replaces the annealing process of the conventional fusion bonding process. Hence, a strong connection of both substrates can be achieved without exposing them to elevated temperatures.

In other words, the main idea is to combine two different bonding techniques, namely the fusion prebonding process of the conventional fusion bonding process and the electrically driven bond process, in particular the ICB process, according to the present invention, that are based on different physical and/or chemical functional principles.

This enables using the advantages of both bonding processes merged into one method. These are in particular low processing temperatures, fast processing speeds, a strong and homogeneously distributed bond strength across the bonding interface, in particular being advantages of the electrical driven bond process, and the possibility to prebond and if necessary correct the substrate alignment, in particular being an advantage of the fusion prebonding process.

In detail, for conventional fusion bonding the annealing step has a big impact on the final bond strength and will most often need several hours of processing time. The approach of combining the fusion prebonding with the electrical driven bond process at substantially lower temperature and processing times according to the present invention will still result in covalent bonds formed at the bond interface and lead to substantially higher bond strengths compared to conventional fusion bonding, where the annealing step is carried out at identical temperatures.

Due to the different nature of the electrical driven bond process, the resulting bond will be performed by chemical reactions between the entire surface area of the bond interface. In contrast, for conventional fusion bonding the chemical reaction at the bond interface will only occur at the locations of silanol groups formed during surface activation, which are naturally limited in number (depending on activation conditions). The electrical driven bond process according to the present invention, however, allows for true hermetic bonding.

During prebonding, a fraction of the Si-OH silanol groups at the interface between the substrates start to form hydrogen bridges due to the (atomic) contact between the substrates, which are transformed into covalent bonds during the electrical driven bond process step.

For example, the covalent bonds can be Si-O-Si covalent bonds.

It is conceivable that the amount of covalent bonds, in particular Si-O-Si covalent bonds, formed during the electrical driven bond process step and thus the bonding strength increases with the processing temperature and time.

In particular, such connections can be established between two silicon wafers with chemisorbed water and/or silanol groups at the surface.

It is however also possible to connect substrates consisting of other materials than silicon by Si-O-Si bonds. In particular, silanol groups can be introduced to the substrate surfaces intended for bonding by a silanization step prior to the prebonding step.

In a preferred embodiment, the prebonding step may be performed at a temperature of less than 200 °C, in particular at room temperature. It has been found that even with such low processing temperatures sufficient bonding strength for substrate handling in the subsequent processing steps can be achieved. This reduces thermal stress on the substrates and/or intrinsic stress within the bond substrate stack.

Preferably, in the step of bonding the first substrate and the second substrate, the electric voltage is applied to the first and/or second substrate such that it stipulates migration of material, in particular ions or vacancies, perpendicular to a contacting interface of the first substrate and the second substrate.

This can be achieved by placing the substrates between two electrodes that are connected to an electric power source. Alternatively, in case of at least partly conducting and/or semiconducting substrates, the substrates themselves can serve as electrodes.

The migration of material perpendicular to the contacting interface can cause interdiffusion of material between the substrates and/or stipulate formation of covalent and/or ionic bonds at the substrate interface. Hence, very strong and highly durable substrate connections can be achieved.

In one example of the method, the step of bonding the first substrate and the second substrate is performed at a temperature of less than 250 °C, in particular between 100 °C and 200 °C. It has been found that this temperature range provides a good compromise between thermal stress on the substrates and bonding strength. It is believed that the elevated temperature facilitates material migration and/or bond formation, thus improving the bonding strength at a given bonding time and/or reducing the necessary bonding time for achieving a desired bonding strength.

The method according to the invention can also comprise further optional steps, in particular cleaning and/or planarizing the first and/or second substrate and/or treating the first and/or second substrate with reactive plasma for surface activation, in particular in accordance with conventional plasma-based low temperature fusion bonding.

These processing steps improve the surface quality and/or reactivity and hence improve the substrate bonding quality, in particular bonding strength and/or homogeneity.

It is also possible to hydrate the first and/or second substrate prior to the step of prebonding in order to increase the number of silanol groups at the surfaces intended for bonding. In addition, this optional step improves the bonding strength and/or homogeneity, in particular of the prebond substrate stack.

In another preferred embodiment, the method comprises the step of observing the alignment of the first and the second substrate after the step of prebonding and before the step of bonding. In case the observation result discloses a misalignment between the first and the second substrate, at least the steps of aligning and prebonding are repeated, particularly after the substrates have been separated again.

This additional step of the method ensures that only well aligned substrates are irreversibly bond together. It reduces the amount of waste products and thus increases the processing yield.

In another variant of the method, in the step of bonding the first substrate and the second substrate, the electrical voltage is applied between the first substrate and the second substrate for a duration of less than 20 min, in particular less than 10 minutes. It has been found that even such short bonding times can result in sufficient bonding strength.

Further advantages and features will become apparent from the following description and from the appended figure, which shows a non-limiting embodiment of the invention.

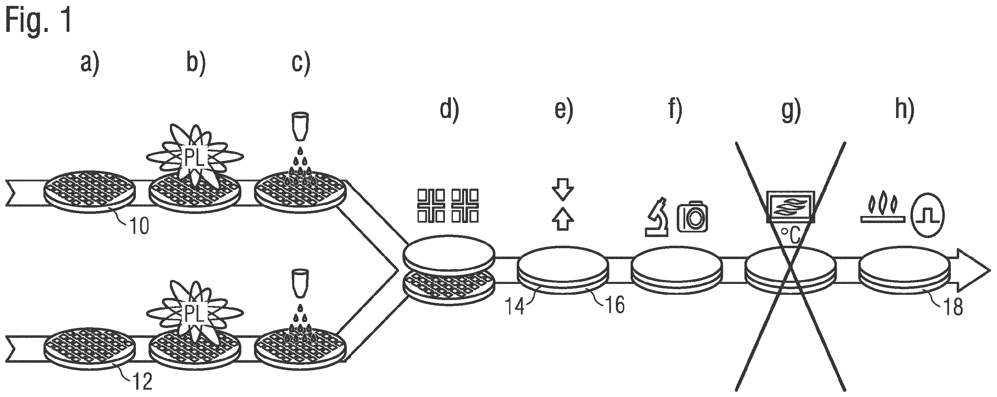

- Fig. 1 schematically shows a method for bonding substrates according to the invention.

In a first step a) of the method, a first substrate 10 and a second substrate 12 are provided. Both substrates 10, 12 as depicted represent silicon wafers.

Of course, the described embodiment is only exemplary. In particular, also other types of substrates and/or materials, e.g. SiC, glass, sapphire etc., can be bonded using the method according to the invention.

In a second step b) of the method, both substrates 10, 12 are cleaned and treated with plasma to activate their surfaces. This step increases the surface energy of the substrates 10, 12 and thus improves formation of chemical bonds during prebonding and/or bonding.

In a third step c) of the method, the substrates 10, 12 are hydrated. This can be achieved by exposing the substrates 10, 12 to a hydration liquid or gas. In particular, the substrates 10, 12 can be sprayed or rinsed with distilled and/or deionized water. This step ensures that a sufficient amount of Si-OH groups is formed at the substrate surfaces, for example by chemisorption of water molecules.

In a fourth step d) of the method, the substrates 10, 12 are aligned to each other. A robot using a camera system that recognizes the wafer contours and/or positioning marks can be applied for a high precision alignment. Also a manual alignment is possible or the substrates 10, 12 are not aligned at all, e.g. in case no positioning marks are present.

In a fifth step e) of the method, the first and second substrate 10, 12 are prebonded together by a fusion prebonding process, in particular plasma-based low temperature fusion prebonding process. This is achieved by bringing the cleaned and hydrated surfaces into (atomic) contact with each other.

Due to the (atomic) contact between the substrates 10, 12, a fraction of the Si-OH silanol groups at the surface of the substrates 10, 12 start forming hydrogen bridges.In the embodiment, the fusion prebonding is performed at room temperature. Of course also higher temperatures, for example up to 100 °C, in particular up to 150 °C, can be applied during this processing step to achieve higher prebonding strength.

The result of the fifth step e) is a prebonded substrate stack 16 consisting of the first and second substrate 10, 12. In the embodiment, it is still possible to detach both substrates 10, 12 from each other. However, the bonding strength of the prebonded substrate stack 16 is enough for substrate handling in the subsequent processing steps without losing (relative) alignment and connection between the substrates 10, 12.

In a sixth step f), the alignment of the first and the second substrate 10, 12 within the prebonded substrate stack 16 is observed, for example by a camera system.

If the observation result discloses a misalignment between the first and the second substrate 10, 12, in particular if the first and second substrate 10, 12 are shifted relative to each other by more than a given threshold value, the steps of aligning and prebonding are repeated, particularly after debonding.

Only if the alignment meets a given specification, the substrates 10, 12 are firmly bonded together.

In the embodiment, the first and second substrate 10, 12 are not bonded together by a conventional high temperature fusion bonding or annealing step. Figure 1 symbolizes this by a crossed out processing step g).

Instead, the prebonded first substrate 10 and second substrate 12 are firmly and/or permanently bond together in a seventh processing step h) by applying an electric voltage with a permanent as well as a pulsed component between them. Alternatively, also a voltage with AC component can be used.

In this electrical driven bond process step the hydrogen bridges formed during the fusion prebonding process step are transformed into covalent bonds.

For example, the covalent bonds can be Si-O-Si covalent bonds.

The electric voltage is applied to the first and second substrate 10, 12 via two electrodes (not shown) between which the prebonded substrate stack 16 is placed.

The voltage is applied in substrate face direction and stipulates migration of material, in particular ions or vacancies, perpendicular to the contacting interface 14 of the first substrate 10 and the second substrate 12.

In the embodiment, the electrical voltage between the first substrate 10 and the second substrate 12 is only applied for a duration of less than 30 minutes, in particular less than 20 minutes, more particularly less than10 minutes. It has been found that such short durations are sufficient to achieve a strong and homogeneous bonding across the contacting interface 14.

Additionally, a temperature less than 200 °C, in particular 150 °C is applied to the substrates 10, 12 during bonding in the seventh processing step h). The elevated temperature facilitates material migration, resulting in a higher bond quality and/or shorter necessary bonding duration.

Importantly, the temperature applied in the seventh processing step h) is still significantly lower than in a conventional fusion bonding process, where processing temperatures of 200 °C - 400 °C or higher are typically applied over an extended period of time, e.g. more than 2 to 10 hours.

In other words, the high temperature treatment or annealing step of a conventional fusion bonding method is replaced by an electrically driven bonding process. This reduces processing time and thermal stress to the substrates 10, 12 in general and results in a firmly bond substrate stack 18 (wafer stack).

## Claims

1. A method for bonding substrates (10, 12) comprising the steps of:
providing a first substrate (10) and a second substrate (12);
aligning the first substrate (10) and the second substrate (12);
prebonding the first substrate (10) and the second substrate (12) by a fusion prebonding process; and
bonding the first substrate (10) and the second substrate (12) by applying an electric voltage between the first substrate (10) and the second substrate (12), wherein said voltage comprises a pulsed or AC component.

2. Method according to claim 1, wherein the fusion prebonding process is **characterized in that** Si-OH groups at the surfaces of the first substrate (10) and the second substrate (12) form hydrogen bridges at a contacting interface (14) between the first and the second substrate (10, 12).

3. Method according to claim 1 or 2, wherein the step of prebonding is performed at a temperature of less than 200 °C, in particular at room temperature.

4. Method according to one of the preceding claims, wherein in the step of bonding the first substrate (10) and the second substrate (12), the electric voltage is applied to the first and second substrate (10, 12) such that it stipulates migration of material, in particular ions or vacancies, perpendicular to a contacting interface (14) of the first substrate (10) and the second substrate (12).

5. Method according to one of the preceding claims, wherein the step of bonding the first substrate (10) and the second substrate (12) is performed at a temperature of less than 250 °C, in particular between 100 °C and 200 °C.

6. Method according to one of the preceding claims, comprising at least one of the additional steps of:
cleaning and/or planarizing the first and/or second substrate (10, 12) and/or;
treating the first and/or second substrate (10, 12) with reactive plasma and/or;
hydrating the first and/or second substrate (10, 12) prior to the step of prebonding and/or;
observing the alignment of the first and the second substrate (10, 12) after the step of prebonding and before the step of bonding, wherein the steps of aligning and prebonding are repeated if the observation result discloses a misalignment between the first and the second substrate (10, 12).

7. Method according to one of the preceding claims, wherein in the step of bonding the first substrate (10) and the second substrate (12), the electrical voltage is applied between the first substrate (10) and the second substrate (12) for a duration of less than 20 min, in particular less than 10 minutes.
